# EUROPEAN PATENT SPECIFICATION

(11) **EP 2 105 979 B1**
(45) Date of publication and mention of the grant of the patent: **29.06.2011**
(21) Application number: 09165856.7
(22) Date of filing: 13.03.2008
(51) Int. Cl.: H01L 51/54

(54) **Anthracene derivatives and organic light-emitting device including the same**
Anthrazenderivate und organische, lichtemittierende Vorrichtung damit
Dérivés d'anthracène et dispositif électroluminescent organique doté de ceux-ci

(30) Priority: 14.03.2007 KR 20070025072
(43) Date of publication of application: 30.09.2009
(62) Divisional of application: 08152670.9
(73) Proprietor: Samsung Mobile Display Co., Ltd., Yongin-city, Gyunggi-do 446-711 (KR)
(72) Inventor: CHOI, Kyung-Hoon, 137-875, Seoul (KR); LEE, Kwan-Hee, Gyeonggi-do (KR); CHUN, Min-Seung, Gyeonggi-do (KR); LIM, Choon-Woo, Gyeonggi-do (KR); PARK, Mie-Hwa, Gyeonggi-do (KR); CHOI, Young-Suck, Gyeonggi-do (KR); PARK, Young-Ho, Gyeonggi-do (KR)
(74) Representative: Gulde Hengelhaupt Ziebig & Schneider

(56) References cited:
- EP-A- 1 717 875
- WO-A-2006/138075
- WO-A-2007/021117
- US-A- 5 935 721
- US-A1- 2006 003 184
- US-A1- 2006 159 952

## Description

### FIELD OF THE INVENTION

The present invention relates to anthracene derivatives and an organic light-emitting device including the same. More particularly, the inventive organic light-emitting device has high efficiency, a low driving voltage, high brightness, and long lifetime, by virtue of using a material having electrical stability and good electron transport capability.

The present invention relates to a prerequisite technology for developing high-quality organic light-emitting devices which are improved in power consumption and lifetime characteristics.

### DESCRIPTION OF THE RELATED ART

Organic light-emitting devices are devices that emit light by recombination of electrons and holes in an organic layer interposed between two electrodes when a current is supplied to the organic layer. Organic light-emitting devices have advantages such as high image quality, a rapid response speed, and a wide viewing angle, and thus, can embody lightweight and thin information display apparatuses. By virtue of such advantages, the organic light-emitting device technology started to rapidly grow. Recently, the application field of organic light-emitting devices has expanded beyond mobile phones to other high-quality information display apparatuses.

With the rapid growth of organic light-emitting devices, the organic light-emitting devices should inevitably compete with other information display devices, such as TFT-LCDs. Conventional organic light-emitting devices are now facing technical limitations in terms of efficiency, lifetime, and power consumption of the devices which significantly affect quantitative and qualitative growth of the devices. Such prior art is exemplified in US2006/0159952A1 and WO2006/138075.

### SUMMARY OF THE INVENTION

The present invention provides an organic light-emitting device capable of enhancing lifetime, brightness, and power consumption efficiency.

According to an aspect of the present invention, there is provided an organic light-emitting device as described in the claims.

### BRIEF DESCRIPTION OF THE DRAWINGS

The above and other features and advantages of the present invention will become more apparent by describing in detail exemplary embodiments thereof with reference to the attached drawings in which:
FIGS. 1A through 1C are schematic sectional views illustrating organic light-emitting devices according to embodiments of the present invention;
FIG. 2 is a graph illustrating current densities of organic light-emitting devices manufactured in Examples 1-2 and Comparative Example 1;
FIG. 3 is a graph illustrating efficiency characteristics of the organic light-emitting devices manufactured in Examples 1-2 and Comparative Example 1; and
FIG. 4 is a graph illustrating lifetime characteristics of the organic light-emitting devices manufactured in Examples 1-2 and Comparative Example 1.

### DETAILED DESCRIPTION OF THE INVENTION

The present invention will now be described more fully with reference to the accompanying drawings, in which exemplary embodiments of the invention are shown.

The present invention provides an organic light-emitting device including: a first electrode; a second electrode; and one or more organic layers interposed between the first electrode and the second electrode.

At least one of the organic layers includes the two different anthracene derivatives represented by Formulae 2 and 3. 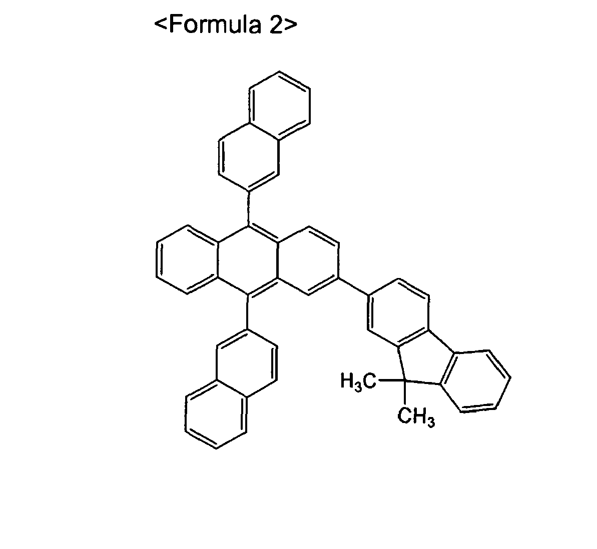 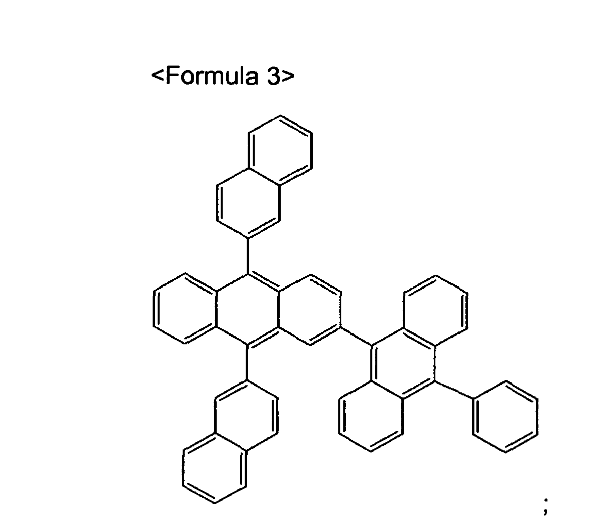 wherein a weight ratio of the two different anthracene derivatives is 5:95 to 95:5.

In the organic light-emitting device according to the present invention, a weight ratio of two different anthracene derivatives may be 5:95 to 95:5. If the content of one of the two different anthracene derivative is too high (greater than 95:5) or too low (less than 5:95), the lifetime of the organic light-emitting device may be reduced or a driving voltage may be increased.

The organic light-emitting device according to the present invention can be variously structured. The organic light-emitting device may further include at least one organic layer selected from the group consisting of an electron transport layer, an electron injection layer, a hole blocking layer, an emitting layer, an electron blocking layer, a hole injection layer, and a hole transport layer, between the first electrode and the second electrode. Preferably, the organic layer may be an electron transport layer or an electron injection layer.

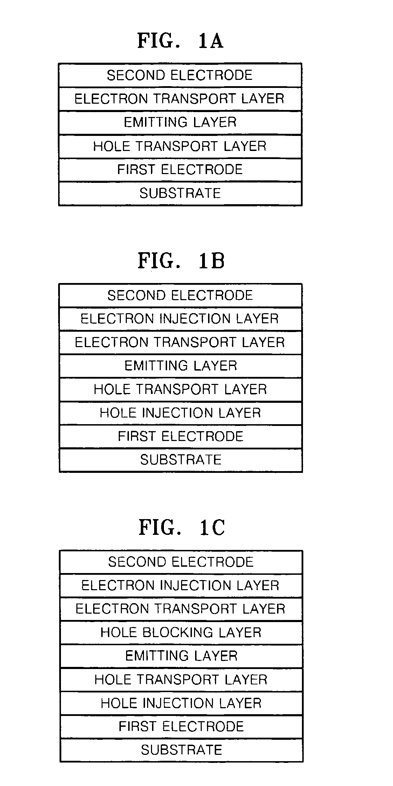

In more detail, organic light-emitting devices according to various embodiments of the present invention are illustrated in FIGS. 1A, 1B, and 1C. Referring to FIG. 1A, an organic light-emitting device has a first electrode/hole transport layer/emitting layer/electron transport layer/second electrode structure. Referring to FIG. 1B, an organic light-emitting device has a first electrode/hole injection layer/hole transport layer/emitting layer/electron transport layer/electron injection layer/second electrode structure. Referring to FIG. 1C, an organic light-emitting device has a first electrode/hole injection layer/hole transport layer/emitting layer/hole blocking layer/electron transport layer/electron injection layer/second electrode structure.. Hereinafter, a method of manufacturing an organic light-emitting device according to an embodiment of the present invention will be described with reference to FIG. 1C. First, a first electrode is formed on a substrate by deposition or sputtering using a first electrode material with a high work function. The first electrode may be an anode. Here, the substrate may be a substrate commonly used in organic light-emitting devices. Preferably, the substrate may be a glass or transparent plastic substrate which is excellent in mechanical strength, thermal stability, transparency, surface smoothness, handling property, and water repellency. The first electrode material may be a transparent material having good conductivity, e.g., indium tin oxide (ITO), indium zinc oxide (IZO), tin oxide (SnO₂), or zinc oxide (ZnO).

Next, a hole injection layer (HIL) may be formed on the first electrode using any one of various methods, e.g., vacuum deposition, spin-coating, casting, or Langmuir-Blodgett (LB) method.

When forming the hole injection layer using a vacuum deposition process, the deposition conditions vary according to the type of a hole injection layer material, the structure and thermal characteristics of the hole injection layer, etc. However, it is preferred that the hole injection layer should be deposited to a thickness of 10Å to 5 µm at a deposition rate of 0.01 to 100Å/sec, at a temperature of 100 to 500°C, and in a vacuum lebel of 10⁻⁸ to 10⁻³ torr.

The hole injection layer material is not particularly limited, and may be a phthalocyanine compound (e.g., copper phthalocyanine) disclosed in U.S. Pat. No. 4,356,429, a Starburst-type amine derivative (e.g., TCTA, m-MTDATA, m-MTDAPB) disclosed in Advanced Material, 6, p.677 (1994), or the like. Here, m-MTDATA is represented by the following formula:

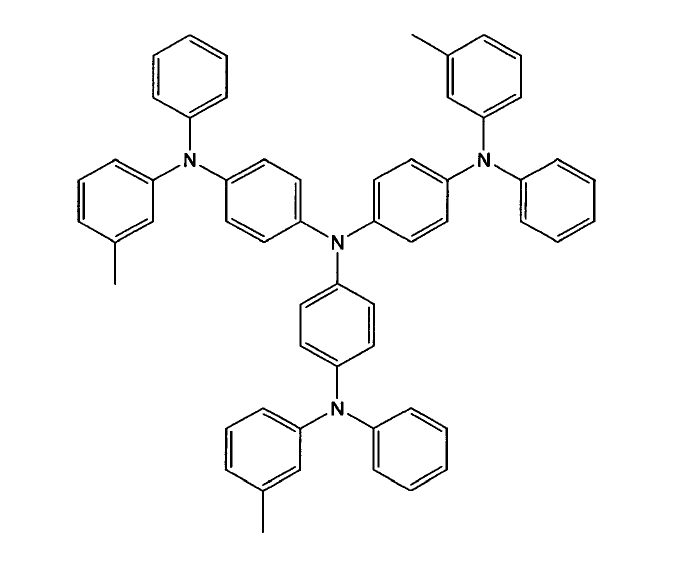

Next, a hole transport layer (HTL) may be formed on the hole injection layer using any one of various methods, e.g., vacuum deposition, spin-coating, casting, or LB method. When forming the hole transport layer using vacuum deposition, the deposition conditions vary according to the type of a used compound, but are generally almost the same as those used for the formation of the hole injection layer. A hole transport layer material is not particularly limited and may be optionally selected from known materials used in hole transport layers, e.g., a carbazole derivative such as N-phenylcarbazole or polyvinylcarbazole; an amine derivative having an aromatic fused ring such as N,N'-bis(3-methylphenyl)-N,N'-diphenyl-[1,1-biphenyl]-4,4'-diamine (TPD) or N,N'-di(naphthalene-1-yl)-N,N'-diphenylbenzidine (α-NPD); etc. Here, α-NPD is represented by the following formula:

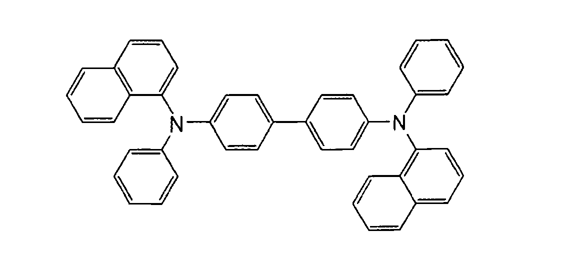

Next, an emitting layer (EML) may be formed on the hole transport layer using vacuum deposition, spin-coating, casting, LB method, or the like. When forming the emitting layer using vacuum deposition, the deposition conditions vary according to the type of a used compound, but are generally almost the same as those used for the formation of the hole injection layer.

An emitting material is not particularly limited and may be optionally selected from known emitting materials, known host materials, and known dopant materials. For example, a host material may be GGH01, GGH02, GDI1403 (Gracel Co., Ltd.), Alq₃, CBP (4,4'-N,N'-dicarbazole-biphenyl), or the like. As for a dopant, a fluorescent dopant may be GGD01, GGD02 (Gracel Co., Ltd.), C545T (Hayashibara Co., Ltd.), or the like, and a phosphorescent dopant may be a red phosphorescent dopant, e.g., PtOEP, RD25, RD61 (UDC), a green phosphorescent dopant, e.g., Ir(PPy)₃ (PPy=2-phenylpyridine), TLEC025, TLEC027 (Takasago Co., Ltd.), or a blue phosphorescent dopant, e.g., F2Irpic. Moreover, a dopant represented by the following formula may also be used:

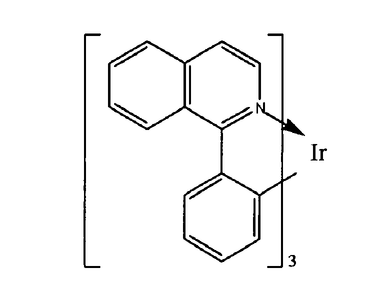

The doping concentration of the dopant is not particularly limited. Generally, the content of the dopant may be 0.01 to 15 parts by weight based on 100 parts by weight of the host and the dopant.

When the emitting layer includes a phosphorescent dopant, a hole blocking layer (HBL) may be further formed on the hole transport layer using vacuum deposition or spin-coating in order to prevent the diffusion of triplet excitons or holes into an electron transport layer. An available hole blocking material may be an oxadiazole derivative, a triazole derivative, a phenanthroline derivative, a hole blocking material disclosed in JP 11-329734(A1), BCP, or the like.

Next, an electron transport layer (ETL) is formed using any one of various methods, e.g., vacuum deposition, spin-coating, or casting. The electron transport layer material may also be a known material, e.g., a quinoline derivative, in particular tris(8-quinolinolate)aluminum (Alq₃).

Preferably, the electron transport layer (ETL) is formed to a thickness of 5 to 70 nm. If the thickness of the electron transport layer is less than 5 nm, a balance between holes and electrons may not be maintained, thereby lowering efficiency. On the other hand, if it exceeds 70 nm, current characteristics may be lowered, thereby increasing a driving voltage.

Next, an electron injection layer (EIL) may be formed on the electron transport layer in order to facilitate the injection of electrons from a cathode. An electron injection layer material is not particularly limited.

The electron injection layer material may be LiF, NaCl, CsF, Li₂O, BaO, or the like. The deposition conditions of the hole blocking layer (HBL), the electron transport layer (ETL), and the electron injection layer (EIL) vary according to the types of used compounds, but are generally almost the same as those for the formation of the hole injection layer.

Finally, a second electrode may be formed on the electron injection layer using vacuum deposition or sputtering using a second electrode forming material. The second electrode may be used as a cathode. The second electrode forming material may be metal or alloy with a low work function, an electroconductive compound, or a mixture thereof. For example, the second electrode forming material may be lithium (Li), magnesium (Mg), aluminum (Al), aluminum-lithium (Al-Li), calcium (Ca), magnesium-indium (Mg-In), magnesium-silver (Mg-Ag), etc. The second electrode may also be a transmissive cathode formed of ITO or IZO to provide a front-emission type device.

An organic light-emitting device according to the present invention can be variously structured, in addition to a structure including a first electrode, a hole injection layer (HIL), a hole transport layer (HTL), an emitting layer (EML), a hole blocking layer

(HBL), an electron transport layer (ETL), an electron injection layer (EIL), and a second electrode, as illustrated in FIG. 1C. When needed, one or two intermediate layers may be further formed.

Hereinafter, Synthesis Examples of a compound (hereinafter, referred to as "compound 2") represented by Formula 2 and a compound (hereinafter, referred to as "compound 3") represented by Formula 3 will be described.

### Examples

### Synthesis Example 1

An intermediate A was synthesized according to Reaction Scheme 1 below.

### <Reaction Scheme 1 >

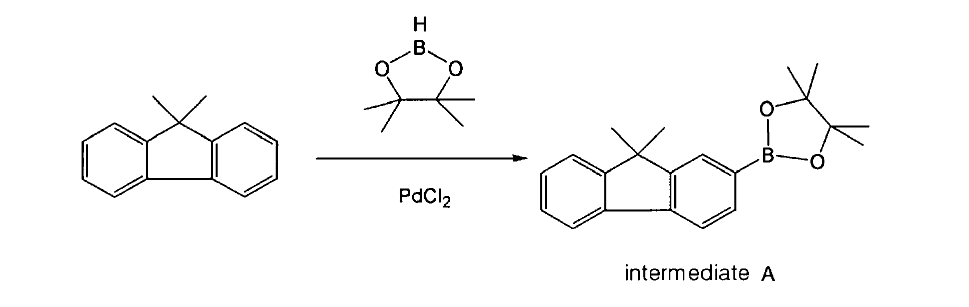

A compound 2 was synthesized using the intermediate A according to Reaction Scheme 2 below:

### <Reaction Scheme 2>

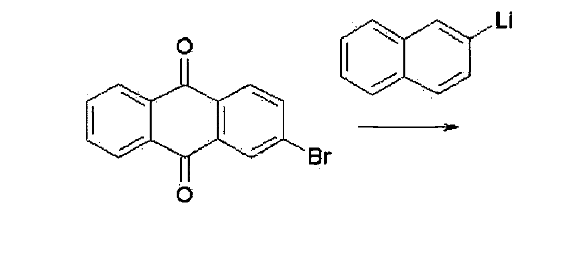

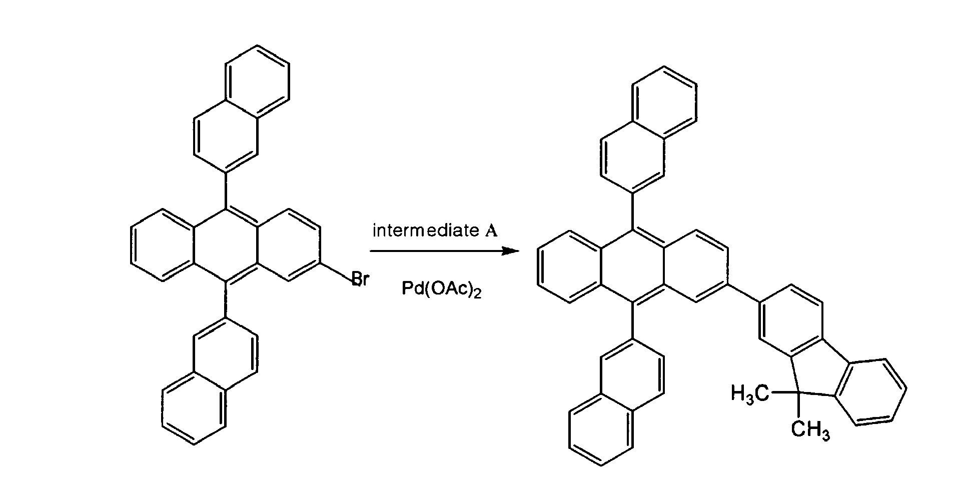

### Synthesis Example 2

An intermediate B was synthesized according to Reaction Scheme 3 below.

### <Reaction Scheme 3>

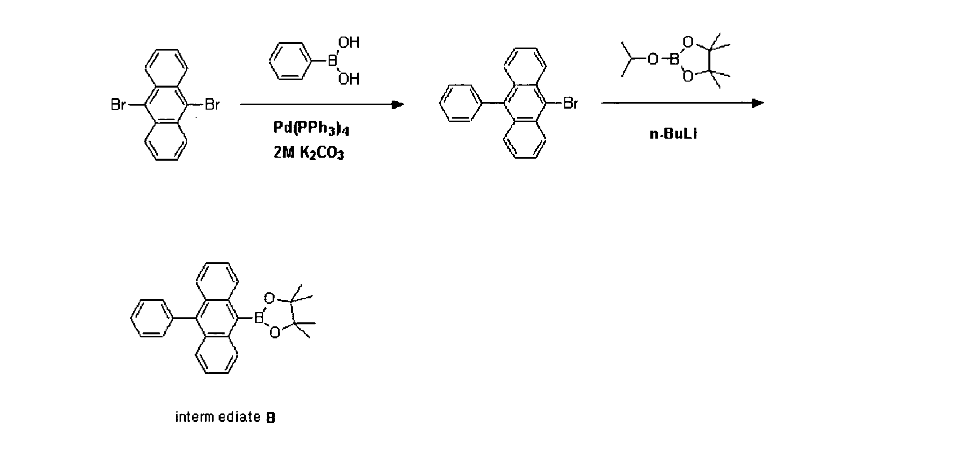

A compound 3 was synthesized according to Reaction Scheme 2 above using the intermediate B instead of the intermediate A.

### Example 1

Organic light-emitting devices (not forming part of the invention) having the following structure were manufactured using a mixture of the compound 2 synthesized in Synthesis Example 1 and sodium quinolinolate (NaQ) (weight ratio: 1:1) as an electron transport layer material: m-MTDATA(750Å)/α-NPD(150Å)/GBHO2(300Å):GBD32(3%)/electron transport layer (200Å)/LiQ(1 0Å)/Al(3000Å).

A 15 Ω/cm² ITO glass substrate (Corning, 1200 ) was cut into pieces of 50 mm x 50 mm x 0.7 mm in size, followed by ultrasonic cleaning in isopropyl alcohol and pure water (5 minutes for each) and UV/ozone cleaning (30 minutes) to form anodes. Then, m-MTDATA was vacuum-deposited to a thickness of 750Å on the anodes to form hole injection layers, and α-NPD was vacuum-deposited to a thickness of 150Å on the hole injection layers to form hole transport layers. Then, GBH02 (Gracel Co., Ltd.) as a blue fluorescent host and GBD32 (Gracel Co., Ltd.) as a dopant (weight ratio (%): 97:3) were vacuum-deposited to a thickness of 300Å on the hole transport layers to form emitting layers. Then, a mixture of the compound 2 and NaQ was vacuum-deposited to a thickness of 200Å on the emitting layers to form electron transport layers. LiQ (10Å, electron injection layers) and Al (3000Å, cathodes) were sequentially vacuum-deposited on the electron transport layers to form LiQ/Al electrodes. This completed the manufacture of organic light-emitting devices.

### Example 2

Organic light-emitting devices were manufactured in the same manner as in Example 1 except that a mixture of the compound 2 synthesized in Synthesis Example 1 and the compound 3 synthesized in Synthesis Example 2 (weight ratio: 1:1) was vacuum-deposited to form electron transport layers.

### Comparative Example 1

Organic light-emitting devices were manufactured in the same manner as in Example 1 except that Alq₃ was used as an electron transport layer material: m-MTDATA(750Å)/α-NPD(150Å)/GBHO2(300Å):GBD32(3%)/Alq₃(200Å)/LiF(80Å)/Al (3000Å).

### Evaluation Example 1

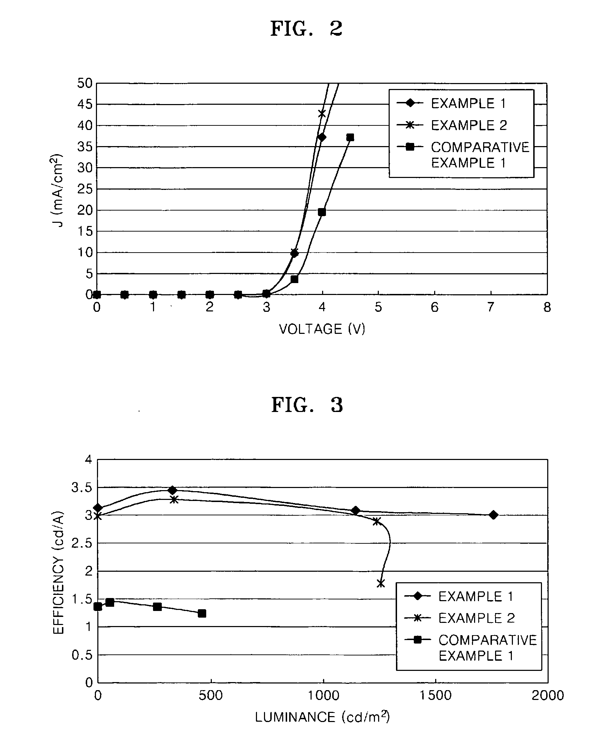

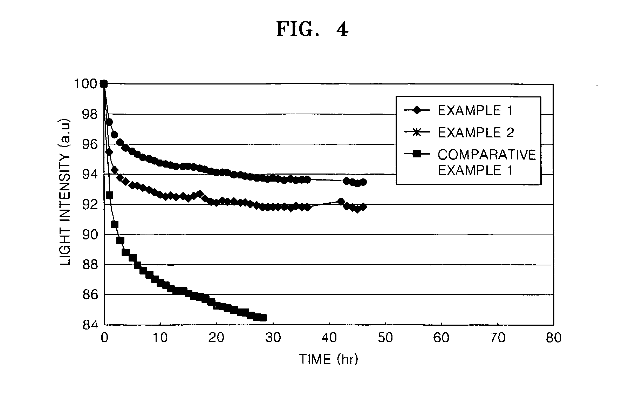

The current density, efficiency, and lifetime characteristics of the organic light-emitting devices manufactured in Examples 1-2 and Comparative Example 1 were evaluated. The graphs for the current density, efficiency, and lifetime characteristics are illustrated in FIGS. 2 through 4, respectively. The current density was evaluated using Source Measurement Unit 238 (Keithley), the efficiency characteristics were evaluated using PR650 (Photo Research Inc.), and the lifetime characteristics were evaluated using Polaronix M6000 (Mcscience).

It could be demonstrated that using a mixture of an anthracene derivative and an ionic metal complex or a mixture of two different anthracene derivatives in an organic light-emitting device improved the electron transport capability. Thus, the anthracene derivatives represented by Formulae 2 and 3 can be efficiently used as an organic layer forming material. The organic light-emitting device with a respective organic layer has a high efficiency, a low driving voltage, high brightness, and a long lifetime.

## Claims

1. An organic light-emitting device comprising:
a first electrode;
a second electrode; and
one or more organic layers interposed between the first electrode and the second electrode, **characterized in that** at least one of the organic layers includes the two different anthracene derivatives represented by Formulae 2 and 3. 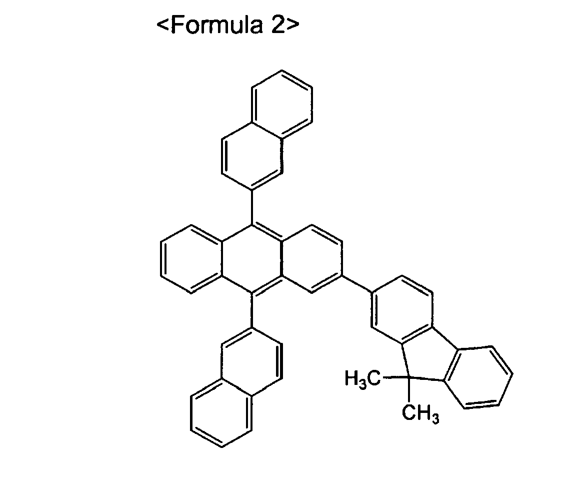 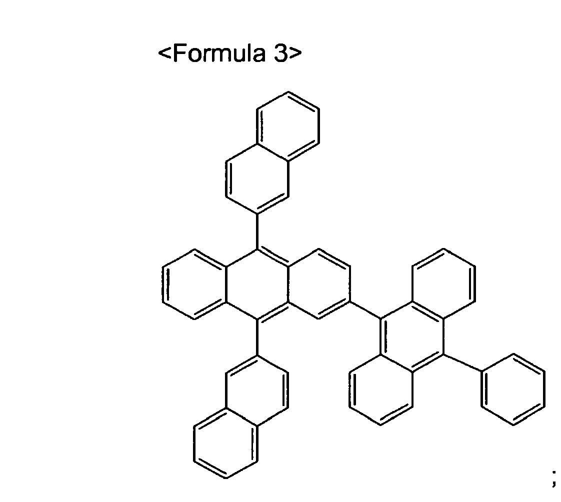 and
wherein a weight ratio of the two different anthracene derivatives is 5:95 to 95:5.

2. The organic light-emitting device of claim 1, wherein the organic layer is an electron transport layer or an electron injection layer.

## Patentansprüche

1. Organische lichtemittierende Vorrichtung, aufweisend:
eine erste Elektrode;
eine zweite Elektrode; und
eine oder mehrere organische Schichten, die zwischen der ersten Elektrode und der zweiten Elektrode eingefügt ist/sind, **dadurch gekennzeichnet, dass** zumindest eine der organischen Schichten die zwei verschiedenen Anthrazenderivate aufweist, die durch Formel 2 und 3 dargestellt sind: 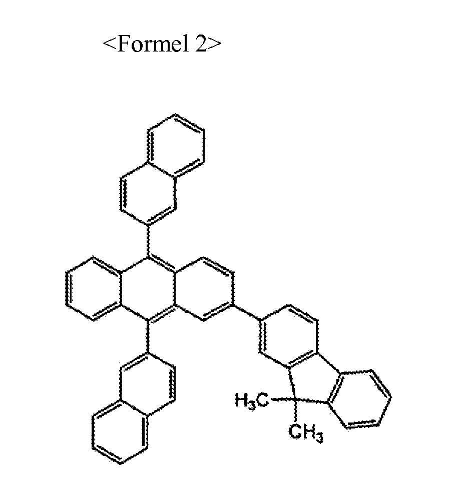 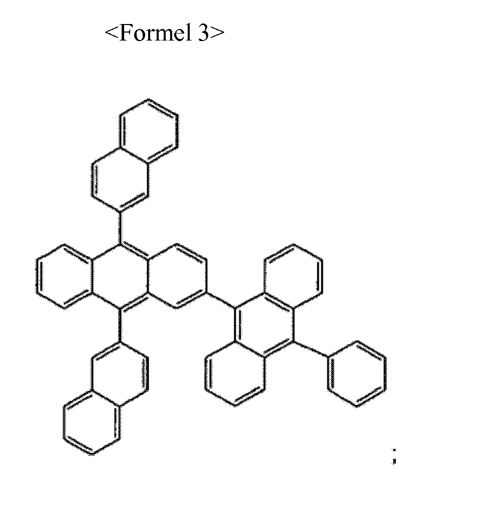 und wobei ein Gewichtsverhältnis der zwei verschiedenen Anthrazenderivate 5:95 bis 95:5 beträgt.

2. Organische lichtemittierende Vorrichtung nach Anspruch 1, wobei die organische Schicht eine Elektronentransportschicht oder eine Elektroneninjektionsschicht ist.

## Revendications

1. Dispositif photoémetteur organique, comprenant :
une première électrode ;
une seconde électrode ; et
une ou plusieurs couches organiques interposées entre la première électrode et la seconde électrode, **caractérisé en ce qu'**au moins une des couches organiques comprend les deux dérivés d'anthracène différents représentés par les formules 2 et 3 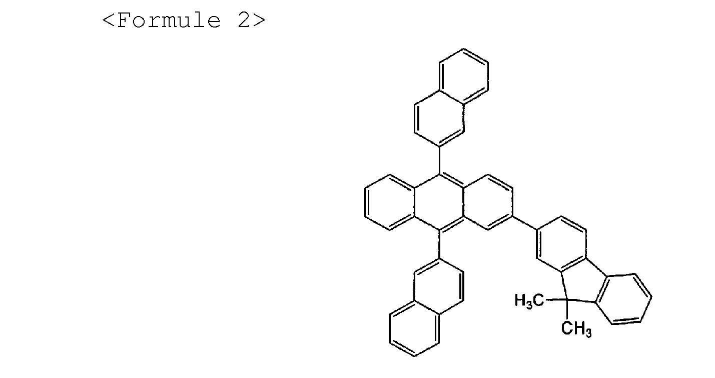 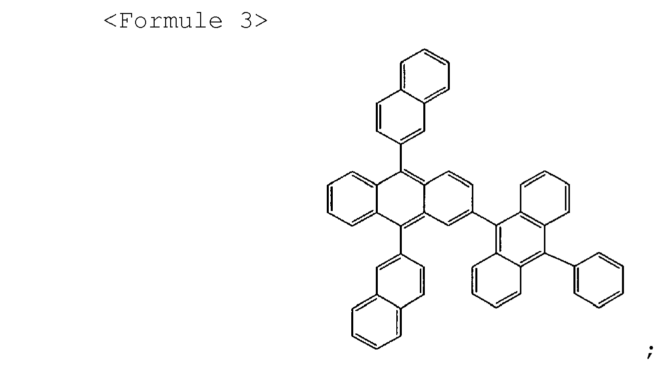 et
le rapport pondéral des deux dérivés d'anthracène différents allant de 5:95 à 95:5.

2. Dispositif photoémetteur organique suivant la revendication 1, dans lequel la couche organique est une couche de transport d'électrons ou une couche d'injection d'électrons.
